# EUROPEAN PATENT SPECIFICATION

(11) **EP 1 513 385 B1**
(45) Date of publication and mention of the grant of the patent: **31.10.2007**
(21) Application number: 03255466.9
(22) Date of filing: 02.09.2003
(51) Int. Cl.: H05K 5/02, H05K 7/14, H01R 9/26

(54) **Controller module responsive to input signals for controlling an electrical appliance**
Steuergerät reagierend auf Eingangssignale zur Steuerung eines elektronischen Geräts
Module de commande répondant à des signaux électriques pour contrôler un appareil électrique

(43) Date of publication of application: 09.03.2005
(73) Proprietor: Excel Cell Electronic Co., Ltd., Taichung (TW)
(72) Inventor: Chiang, Ching-Chung, Wu-Feng Hsiang Taichung Hsien (TW)
(74) Representative: Robson, Aidan John

(56) References cited:
- EP-A- 0 912 080
- DE-U- 29 603 161
- US-A- 5 838 535
- US-A1- 2002 187 670

## Description

The invention relates to a controller module, more particularly to a controller module responsive to input signals for controlling an electrical appliance.

German utility model No. DE-U-29603161 discloses an electrical connector that is not adapted for use with test probes.

US patent application No. US-A-2002/0187670 discloses a connection element which is placed in an insulating casing and which comprises at least one connection spring intended to grip the conducting core of a cable to provide an electrical connection between the cable and electrical plant.

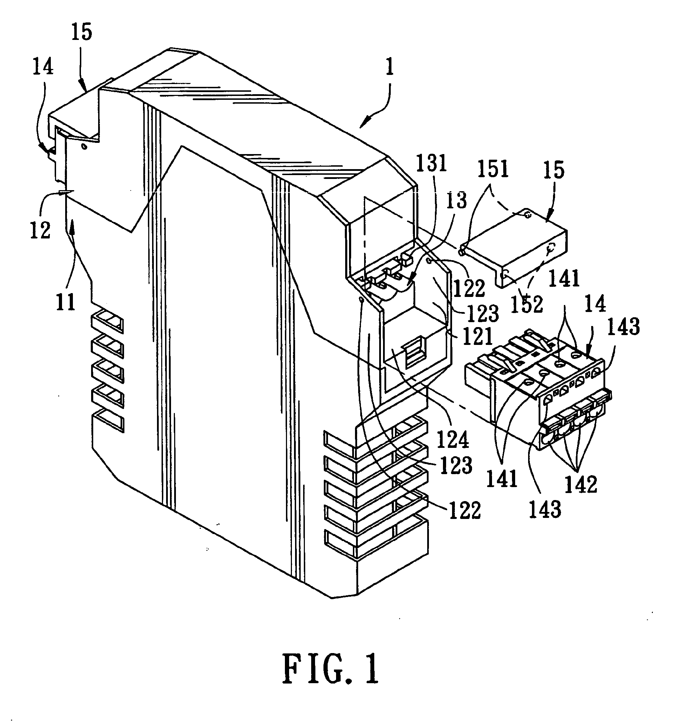

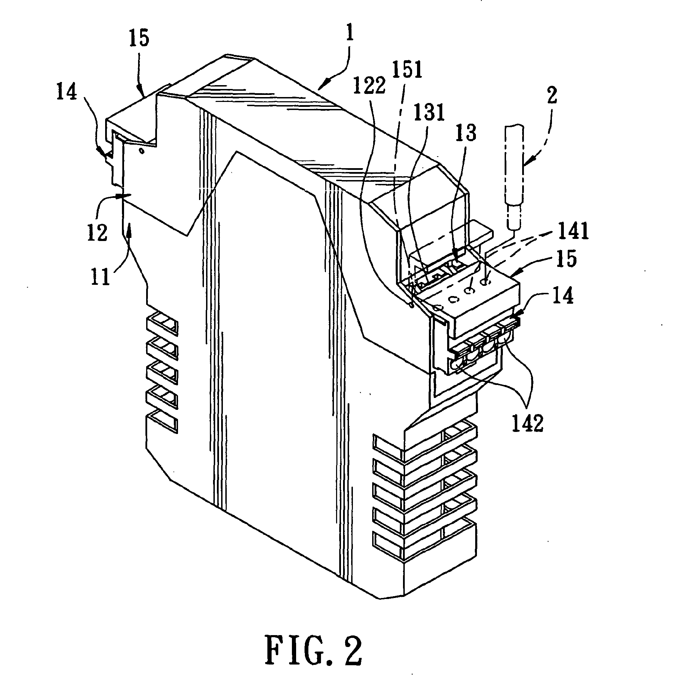

Figures 1 and 2 illustrate a conventional controller module 1 responsive to input signals for controlling an electrical appliance (not shown). The conventional controller module 1 includes a circuit unit 13 disposed in a hollow case 11, a cover member 12, two terminal blocks 14, and two positioning members 15. The circuit unit 13 includes two connecting seats 131 (only one is shown) that are exposed from an open end of the case 11. The cover member 12 is mounted detachably on the open end of the case 11, and has opposite side walls 123 and a bottom wall 124 in each of opposite lateral sides thereof so as to cooperate with the corresponding connecting seat 131 to confine a block receiving space. Each terminal block 14 is mounted detachably in a respective block receiving space through an opening 121 confined by the side walls 123 and is connected electrically to a respective connecting seat 131. Each terminal block 14 has a mounting side connected electrically to the corresponding connecting seat 131, a top side formed with a set of probe insertion holes 141 for insertion of a set of test probes 2 (only one is shown in Figure 2), and an input side opposite to the mounting side and formed with a set of input insertion holes 142 for insertion of a set of external terminals (not shown). Each positioning member 15 is mounted pivotally on a corresponding lateral side of the cover member 12, and is disposed at the opening 121 in the corresponding lateral side of the cover member 12. Each positioning member 15 is formed with opposite pivot posts 151 that are pivotally retained in pivot holes 122 formed in the side walls 123 of the corresponding lateral side of the cover member 12, respectively, and a plurality of positioning posts 152 received in a plurality of positioning holes 143 formed in the input side of the corresponding terminal block 14. By virtue of the positioning member 15, the terminal blocks 14 can be positioned on the connecting seats 131.

In use, one of the terminal blocks 14 can be used to connect the circuit unit 13 to an electrical appliance, whereas the other of the terminal blocks 14 can be used to connect the circuit unit 13 to external devices, such as sensors and the like. Accordingly, the circuit unit 13 can control the electrical appliance based on input signals received from the external devices.

By changing the circuit unit 13, the controller module 1 can be used to control different electrical appliances according to different operating requirements.

Moreover, by virtue of the probe insertion holes 141 in the terminal blocks 14, testing of the circuit unit 31 can be conducted through the test probes 2 without the need to remove the circuit unit 13 from the case 11.

It is noted that the positioning members 15 must be pivoted upwardly so as to expose the probe insertion holes 141 for insertion of the test probes 2 during testing, thereby resulting in inconvenience.

Therefore, the object of the present invention is to provide a controller module that can eliminate the aforesaid drawback of the prior art.

The invention in its various aspects is defined in the independent claims below, to which reference should now be made. Advantageous features are set forth in the appendant claims.

Other features and advantages of the present inventionwill become apparent in the following detailed description of the preferred embodiments with reference to the accompanying drawings, of which:
Figure 1 is a partly exploded perspective view of a conventional controller module;
Figure 2 is an assembled perspective view of the conventional controller module;
Figure 3 is an exploded perspective view showing the first preferred embodiment of a controller module according to the present invention;
Figure 4 is a partly exploded perspective view of the first preferred embodiment;
Figure 5 is an assembled perspective view of the first preferred embodiment;
Figure 6 is a partly exploded perspective view showing the second preferred embodiment of a controller module according to the present invention; and
Figure 7 is an assembled perspective view of the second preferred embodiment.

Before the present invention is described in greater detail, it should be noted that like elements are denoted by the same reference numerals throughout the disclosure.

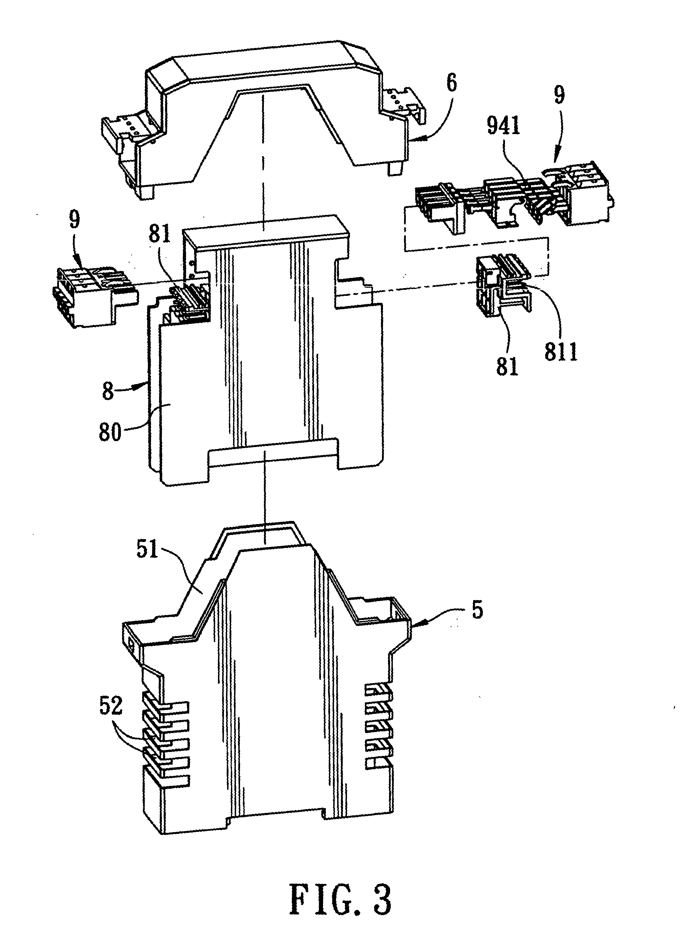

Referring to Figures 3 to 5, the first preferred embodiment of a controller module 3 according to the present invention is shown to be responsive to input signals for controlling an electrical appliance (not shown). The controller module 3 includes a circuit unit 8, a hollow case 5, a cover member 6, two terminal blocks 9, and two positioning members 100.

The circuit unit 8 includes a control circuit 80 adapted to be connected electrically to the electrical appliance, and two connecting seats 81 coupled electrically to the control circuit 80. Each connecting seat 81 is formed with a set of first conductive contacts 811, as shown in Figure 3.

The case 5 has an open end 51. The circuit unit 8 is disposed in the case 5 such that the connecting seats 81 of the circuit unit 8 are exposed from the open end 51 of the case 5. In this embodiment, the case 5 has opposite lateral sides, each of which is formed with a plurality of vent holes 52 for heat dissipation.

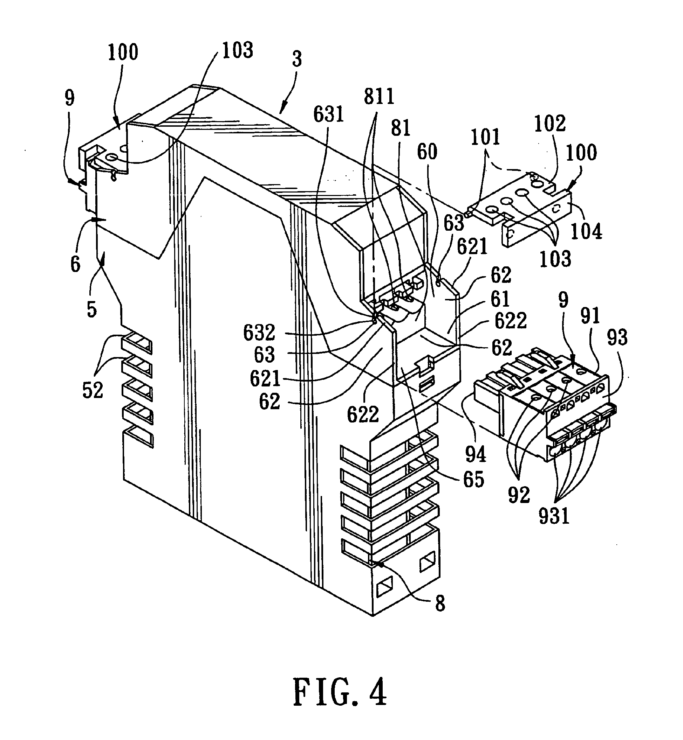

The cover member 6 is mounted detachably on the open end 51 of the case 5. In this embodiment, as best shown in Figure 4, the cover member 6 has opposite lateral sides, each of which is formed with first and second openings 60, 61. Each lateral side of the cover member 6 has opposite side walls 62, each of which has a pivot edge 621 formed with a pivot groove 63, and a vertical edge 622. The pivot edges 621 of the side walls 62 in each lateral side confine the first opening 60. The vertical edges 622 of the side walls 62 in each lateral side confine the second opening 61. Each lateral side of the cover member 6 further has a bottom wall 65 extending between the side walls 62 and spaced apart from the pivot edges 621 of the side walls 62. Each connecting seat 81 of the circuit unit 8 is spaced apart from the vertical edges 622 of the side walls 62 in a corresponding one of the lateral sides by the bottom wall 65. In each lateral side of the cover member 6, the side walls 62, the bottom wall 65 and a corresponding one of the connecting seats 81 cooperate to confine a block receiving space 64. In this embodiment, each pivot groove 63 has a restricted upper neck portion 631 and a wider lower receiving portion 632, and is formed during molding of the cover member 6.

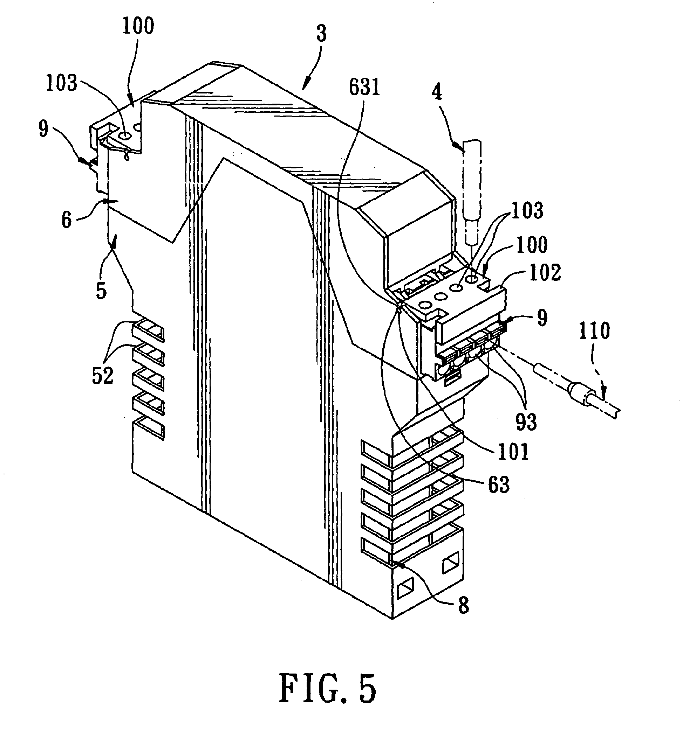

Each terminal block 9 is mounted detachably in the block receiving space 64 through the second opening 61 in a corresponding one of the lateral sides of the cover member 6 such that each terminal block 9 is accessible through the second opening 61 in the corresponding one of the lateral sides of the cover member 6. Each terminal block 9 has a mounting side 94 provided with a set of second conductive contacts 941 that are each connected electrically and removably to a first conductive contact 811 in a corresponding one of the connecting seats 81, and an input side 93 opposite to the mounting side 94 and formed with a set of input insertion holes 931 adapted for insertion of a set of external terminals 110 (see Figure 5) so as to permit connection of the external terminals 110 to the first conductive contacts 811 in the corresponding one of the connecting seats 81 through the second conductive contacts 941 and a top side 91 formed with a set of probe insertion holes 92 adapted for insertion of a set of test probes 4 (only one is shown in Figure 5) so as to permit connection of the test probes 4 to the first conductive contacts 811 in the corresponding one of the connecting seats 81 through the second conductive contacts 941.

The positioning members 100 are mounted pivotally on the lateral sides of the cover member 6. Each positioning member 100 is disposed at the first opening 60 in a corresponding one of the lateral sides of the cover member 6 for positioning a respective terminal block 9 on the corresponding connecting seat 81. Each positioning member 100 has a first plate body 102 disposed above the top side 91 of the respective terminal block 9 and formed with a set of positioning holes 103 that are registered with the probe insertion holes 92 in the top side 91 of the respective terminal block 9, and a second plate body 104 connected to the first plate body 102, extending into the second opening 61 in the corresponding one of the lateral sides of the cover member 6 and engaging the input side 93 of the corresponding one of the terminal blocks 9 without covering the input insertion holes 931. The first plate body 102 of each positioning member 100 is formed with opposite pivot posts 101 that are pivotally retained in the pivot grooves 63 in the side walls 62 of the corresponding one of the lateral sides of the cover member 6, as shown in Figure 5. In this embodiment, each pivot post 101 is received in the lower receiving portion 632 of a corresponding one of the pivot grooves 63, and has a size larger than that of the upper neck portion 631 and smaller than that of the lower receiving portion 632.

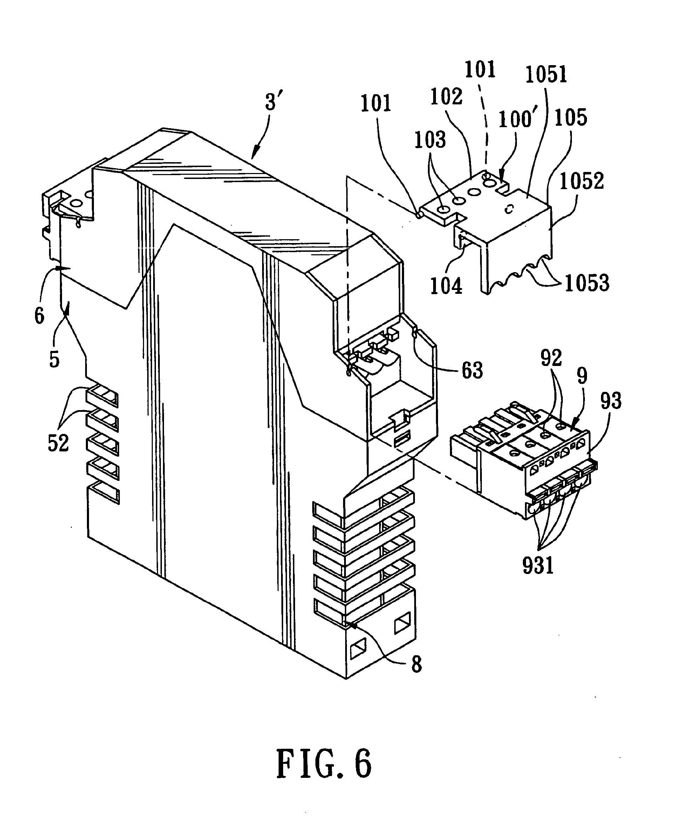

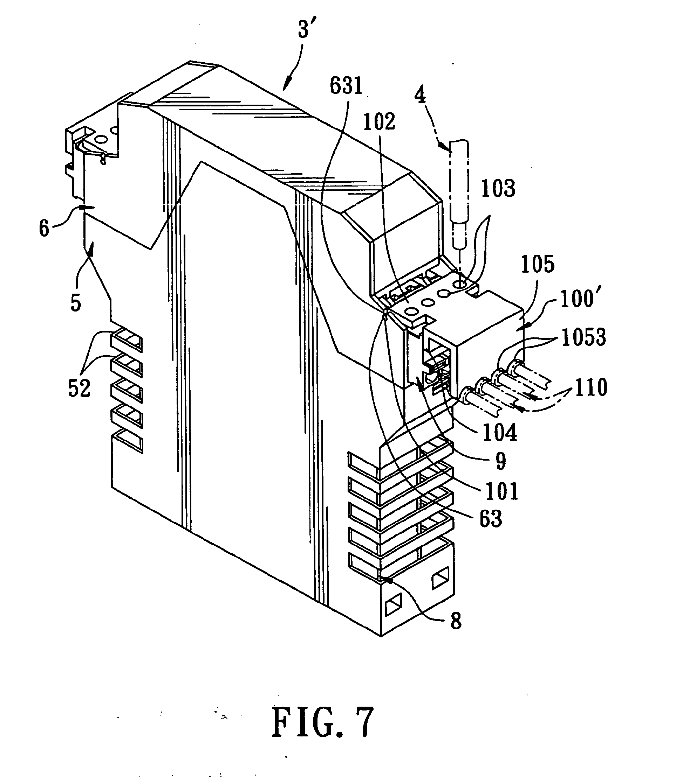

Figures 6 and 7 illustrate the second preferred embodiment of a controller module 3' according to this invention, which is amodificationof the first preferred embodiment. Unlike the previous embodiment, each positioning member 100' further has a third plate body 105 with a connecting portion 1051 connected to a junction of the first and second plate bodies 102, 104, and a positioning portion 1052 connected to the connecting portion 1051 and extending parallel to the second plate body 104. The positioning portion 1052 is formed with a set of notches 1053 registered with the input insertion holes 931 in the input side 93 of the corresponding terminal block 9.

To sum up, due to the presence of the positioning holes 103 in the positioning members 100, 100', the test probes 4 can be directly inserted into the probe insertion holes 92 in the terminal blocks 9 through the positioning holes 103 without pivoting the positioning members 100, 100', thereby resulting in convenience during use. Furthermore, reliable positioning of the test probes 4 can be ensured.

## Claims

1. A controller module (3, 3') responsive to input signals for controlling an electrical appliance, said controller module (3, 3') **characterized by**:
a circuit unit (8) including a control circuit (80) adapted to be connected electrically to the electrical appliance, and a connecting seat (81) coupled electrically to said control circuit (80) and formed with a set of first conductive contacts (811);
ahollowcase (5) having an open end (51), said circuit unit (8) being disposed in said case (5) such that said connecting seat (81) of said circuit unit (8) is exposed from said open end (51) of said case (5);
a cover member (6) mounted detachably on said open end (51) of said case (5), said cover member (6) being formed with first and second openings (60, 61), said cover member (6) having opposite side walls (62), each of which has a pivot edge (621) formed with a pivot groove (63), and a vertical edge (622), said pivot edges (621) of said side walls (62) confining said first opening (60), said vertical edges (622) of said side walls (62) confining said second opening (61), said cover member (6) further having a bottom wall (65) extending between said side walls (62) and spaced apart from said pivot edges (621) of said side walls (62), said connecting seat (81) of said circuit unit (8) being spaced apart from said vertical edges (622) of said side walls (62) by said bottom wall (65), said side walls (62), said bottom wall (65) and said connecting seat (81) cooperating to confine a block receiving space (64);
a terminal block (9) mounted detachably in said block receiving space (64) through said second opening (61) in said cover member (6) such that said terminal block (9) is accessible through said second opening (61), said terminal block (9) having a mounting side (94) provided with a set of second conductive contacts (941) that are each connected electrically and removably to one of said first conductive contacts (811), an input side (93) opposite to said mounting side (94) and formed with a set of input insertion holes (931) adapted for insertion of a set of external terminals (110) so as to permit connection of the external terminals (110) to said first conductive contacts (811) through said second conductive contacts (941) and a top side (91) formed with a set of probe insertion holes (92) adapted for insertion of a set of test probes (4) so as to permit connection of the test probes (4) to said first conductive contacts (811) through said second conductive contacts (941); and
a positioning member (100, 100') mounted pivotally on said cover member (6) and disposed at said first opening (60) in said cover member (6) for positioning said terminal block (9) on said connecting seat (81), said positioning member (100, 100') having a first plate body (102) disposed above said top side (91) of said terminal block (9) and formed with a set of positioning holes (103) that are registered with said probe insertion holes (92) in said top side (91) of said terminal block (9) and a second plate body (104) connected to said first plate body (102), extending into said second opening (61) in said cover member (6), and engaging said input side (93) of said terminal block (9) without covering said input insertion holes (931), said first plate body (102) being formed with opposite pivot posts (101) that are pivotally retained in said pivot grooves (63), and thereby the test probes (4) can be directly inserted into said probe insertion holes (92) through said positioning holes (103) without pivoting said positioning member (100, 100'), thus providing convenience in said module during use.

2. The controller module as claimed in Claim 1, wherein each of said pivot grooves (63) has a restricted upper neck portion (631) and a wider lower receiving portion (632), each of said pivot posts (101) being received in said lower receiving portion (632) and having a size larger than that of said upper neck portion (631) and smaller than that of said lower receiving portion (632).

3. The controller module as claimed in Claim 1 or 2, wherein said positioning member (100') further has a third plate body (105) with a connecting portion (1051) connected to a junction of said first and second plate bodies (102, 104), and a positioning portion (1052) connected to said connecting portion (1051) and extending parallel to said second plate body (104), said positioning portion (1052) being formed with a set of notches (1053) registered with said input insertion holes (931).

4. A controller module for an electrical appliance comprising a circuit unit (8) disposed in a case (5), and being exposed at an open end (51) of the case (5) and electrically coupled to a control circuit (80) within the case (5), a connecting seat (81) having a set of first conductive contacts (811),
a terminal block (9) mounted detachably in the case (5) and having a mounting side (94) provided with second conductive contacts (941) that are removably connected to respective ones of the first conductive contacts (811),
an input side (93) opposite to the mounting side (94) and formed with input insertion holes (931) for insertion of external terminals (110), and an upper side (91) formed with probe insertion holes (92) for insertion of test probes (4),
and a positioning member (100) mounted pivotally on the case (5) for positioning the terminal block (9) on the connecting seat (81) and having corresponding positioning holes (103) provided therein,
and wherein the test probes (4) can be directly inserted into the probe insertion holes (92) through the positioning holes (103) without pivoting the positioning member (100), thus providing convenience in the module during use.

## Patentansprüche

1. Steuermodul (3, 3'), das auf Eingangssignale zum Steuern eines elektrischen Geräts anspricht, wobei das genannte Steuermodul (3, 3') **gekennzeichnet ist durch**:
eine Schaltungseinheit (8) mit einer Steuerschaltung (80) zum elektrischen Verbinden mit dem elektrischen Gerät und einem Verbindungssitz (81), der elektrisch mit der genannten Steuerschaltung (80) gekoppelt ist und mit einem Satz erster leitender Kontakte (811) ausgebildet ist;
ein hohles Gehäuse (5) mit einem offenen Ende (51), wobei die genannte Schaltungseinheit (8) so in dem genannten Gehäuse (5) angeordnet ist, dass der genannte Verbindungssitz (81) der genannten Schaltungseinheit (8) vom genannten offenen Ende (51) des genannten Gehäuses (5) offenliegt;
ein abnehmbar am genannten offenen Ende (51) des genannten Gehäuses (5) montiertes Deckelelement (6), wobei das genannte Deckelelement (6) mit einer ersten und einer zweiten Öffnung (60, 61) ausgebildet ist, wobei das genannte Deckelelement (6) einander gegenüberliegende Seitenwände (62) hat, die jeweils einen mit einer Gelenknut (63) ausgebildeten Gelenkrand (621) und einen vertikalen Rand (622) haben, wobei die genannten Gelenkränder (621) der genannten Seitenwände (62) die genannte erste Öffnung (60) begrenzen, wobei die genannten vertikalen Ränder (622) der genannten Seitenwände (62) die genannte zweite Öffnung (61) begrenzen, wobei das genannte Deckelelement (6) ferner eine untere Wand (65) hat, die zwischen den genannten Seitenwänden (62) verläuft und von den genannten Gelenkrändern (621) der genannten Seitenwände (62) beabstandet ist, wobei der genannte Verbindungssitz (81) der genannten Schaltungseinheit (8) **durch** die genannte untere Wand (65) von den genannten vertikalen Rändern (622) der genannten Seitenwände (62) beabstandet ist, wobei die genannten Seitenwände (62), die genannte untere Wand (65) und der genannte Verbindungssitz (81) zum Begrenzen eines Blockaufnahmeraums (64) zusammenwirken;
einen Klemmenblock (9), der **durch** die genannte zweite Öffnung (61) in dem genannten Deckelelement (6) abnehmbar in dem genannten Blockaufnahmeraum (64) montiert ist, so dass der genannte Klemmenblock (9) **durch** die genannte zweite Öffnung (61) zugänglich ist, wobei der genannte Klemmenblock (9) Folgendes hat: eine Befestigungsseite (94), die mit einem Satz zweiter leitender Kontakte (941) versehen ist, die jeweils elektrisch und abnehmbar mit einem der genannten ersten leitenden Kontakte (811) verbunden sind, eine Eingangsseite (93), die der genannten Befestigungsseite (94) entgegengesetzt und mit einem Satz Eingangseinstecklöchern (931) zum Einführen eines Satzes externer Anschlüsse (110) ausgebildet ist, um das Verbinden der externen Anschlüsse (110) mit den genannten ersten leitenden Kontakten (811) **durch** die genannten zweiten leitenden Kontakte (941) zuzulassen, und eine Oberseite (91), die mit einem Satz von Sondeneinstecklöchern (92) zum Einführen eines Satzes von Prüfsonden (4) ausgebildet ist, um das Verbinden der Prüfsonden (4) mit den genannten ersten leitenden Kontakten (811) **durch** die genannten zweiten leitenden Kontakte (941) zuzulassen; und
ein Positionierungselement (100, 100'), das am genannten Deckelelement (6) angelenkt ist und an der genannten ersten Öffnung (60) im genannten Deckelelement (6) angeordnet ist, zum Positionieren des genannten Klemmenblocks (9) an dem genannten Verbindungssitz (81), wobei das genannte Positionierungselement (100, 100') einen ersten Plattenkörper (102), der über der genannten Oberseite (91) des genannten Klemmenblocks (9) angeordnet und mit einem Satz Positionierungslöcher (103) ausgebildet ist, die mit den genannten Sondeneinstecklöchern (92) in der genannten Oberseite (91) des genannten Klemmenblocks (9) lagegenau sind, und einen mit dem genannten ersten Plattenkörper (102) verbundenen zweiten Plattenkörper (104) hat, der sich in die genannte zweite Öffnung (61) im genannten Deckelelement (6) erstreckt und mit der genannten Eingangsseite (93) des genannten Klemmenblocks (9) in Eingriff ist, ohne die genannten Eingangseinstecklöcher (931) zu bedecken, wobei der genannte erste Plattenkörper (102) mit einander entgegengesetzten Drehzapfen (101) ausgebildet ist, die in den genannten Gelenknuten (63) gelenkig festgehalten werden, und wodurch die Prüfsonden (4) **durch** die genannten Positionierungslöcher (103) direkt in die genannten Sondeneinstecklöcher (92) eingeführt werden können, ohne das genannte Positionierungselement (100, 100') zu schwenken, wodurch das genannte Modul im Gebrauch bedienungsfreundlich ist.

2. Steuermodul nach Anspruch 1, bei dem jede der genannten Gelenknuten (63) einen verengten oberen Halsabschnitt (631) und einen weiteren unteren Aufnahmeabschnitt (632) hat, wobei jeder der genannten Drehzapfen (101) in dem genannten unteren Aufnahmeabschnitt (632) aufgenommen wird und eine Größe hat, die größer als die des genannten oberen Halsabschnitts (631) und kleiner als die des genannten unteren Aufnahmeabschnitts (632) ist.

3. Steuermodul nach Anspruch 1 oder 2, bei dem das genannte Positionierungselement (100') ferner einen dritten Plattenkörper (105) hat mit einem Verbindungsabschnitt (1051), der mit einer Verbindungsstelle des genannten ersten und zweiten Plattenkörpers (102, 104) verbunden ist, und einem Positionierungsabschnitt (1052), der mit dem genannten Verbindungsabschnitt (1051) verbunden ist und parallel zum genannten zweiten Plattenkörper (104) verläuft, wobei der genannte Positionierungsabschnitt (1052) mit einem Satz Aussparungen (1053) ausgebildet ist, die mit den genannten Eingangseinstecklöchern (931) lagegenau sind.

4. Steuermodul für ein elektrisches Gerät, umfassend eine Schaltungseinheit (8), die in einem Gehäuse (5) angeordnet ist und an einem offenen Ende (51) des Gehäuses (5) offen liegt und elektrisch mit einer Steuerschaltung (80) in dem Gehäuse (5) gekoppelt ist, einen Verbindungssitz (81) mit einem Satz erster leitender Kontakte (811),
einen Klemmenblock (9), der abnehmbar in dem Gehäuse montiert ist und eine Befestigungsseite (94) hat, die mit zweiten leitenden Kontakten (941) versehen ist, die abnehmbar mit jeweiligen der ersten leitenden Kontakte (811) verbunden sind,
eine Eingangsseite (93), die der genannten Befestigungsseite (94) entgegengesetzt und mit Eingangseinstecklöchern (931) zum Einführen externer Anschlüsse (110) ausgebildet ist, und eine Oberseite (91), die mit Sondeneinstecklöchern (92) zum Einführen von Prüfsonden (4) ausgebildet ist,
und ein Positionierungselement (100), das am Gehäuse (5) angelenkt ist zum Positionieren des Klemmenblocks (9) an dem Verbindungssitz (81) und mit entsprechenden Positionierungslöchern (103) versehen ist,
und wobei die Prüfsonden (4) durch die Positionierungslöcher (103) direkt in die Sondeneinstecklöcher (92) eingeführt werden können, ohne das Positionierungselement (100) zu schwenken, wodurch das Modul im Gebrauch bedienungsfreundlich ist.

## Revendications

1. Module de contrôleur (3, 3') sensible à des signaux d'entrée pour commander un appareil électrique, ledit module de contrôleur (3, 3') étant **caractérisé par**
une unité de circuit (8) comportant un circuit de commande (80) adaptée pour être connectée électriquement à l'appareil électrique, et un siège de connexion (81) couplé électriquement audit circuit de commande (80) et formé avec un ensemble de premiers contacts conducteurs (811) ;
un boîtier creux (5) ayant une extrémité ouverte (51), ladite unité de circuit (8) étant disposée dans ledit boîtier (5) de telle sorte que ledit siège de connexion (81) de ladite unité de circuit (8) soit exposé au niveau de ladite extrémité ouverte (51) dudit boîtier (5) ;
un élément de couvercle (6) monté de façon détachable sur ladite extrémité ouverte (51) dudit boîtier (5), ledit élément de couvercle (6) étant formé avec des première et seconde ouvertures (60, 61), ledit élément de couvercle (6) ayant des parois latérales opposées (62), chacune ayant un bord de pivotement (621) formé avec une rainure de pivotement (63), et un bord vertical (622), lesdits bords de pivotement (621) desdites parois latérales (62) confinant ladite première ouverture (60), lesdits bords verticaux (622) desdites parois latérales (62) confinant ladite seconde ouverture (61), ledit élément de couvercle (6) comportant en outre une paroi de fond (65) s'étendant entre lesdites parois latérales (62) et espacée desdits bords de pivotement (621) desdites parois latérales (62), ledit siège de connexion (81) de ladite unité de circuit (8) étant espacé desdits bords verticaux (622) desdites parois latérales (62) par ladite paroi de fond (65), lesdites parois latérales (62), ladite paroi de fond (65) et ledit siège de connexion (81) coopérant pour confiner un espace de réception de bloc (64) ;
un bloc de jonction (9) monté de façon détachable dans ledit espace de réception de bloc (64) à travers ladite seconde ouverture (61) dans ledit élément de couverture (6) de telle sorte que ledit bloc de jonction (9) soit accessible à travers ladite seconde ouverture (61), ledit bloc de jonction (9) ayant un côté de montage (94) doté d'un ensemble de deuxièmes contacts conducteurs (941) qui sont connectés chacun électriquement et amoviblement à l'un desdits premiers contacts conducteurs (811), un côté d'entrée (93) opposé audit côté de montage (94) et formé avec un ensemble de trous d'insertion d'entrée (931) adaptés pour l'insertion d'un ensemble de bornes externes (110) de façon à permettre la connexion des bornes externes (110) avec lesdits premiers contacts conducteurs (811) par le biais desdits deuxièmes contacts conducteurs (941) et un côté supérieur (91) formé avec un ensemble de trous d'insertion de sondes (92) adapté pour l'insertion d'un ensemble de sondes d'essai (4) de façon à permettre la connexion des sondes d'essai (4) auxdits premiers contacts conducteurs (811) par le biais desdits deuxièmes contacts conducteurs (941) ; et
un élément de positionnement (100, 100') monté de façon pivotante sur ledit élément de couvercle (6) et disposé au niveau de ladite première ouverture (60) dans ledit élément de couvercle (6) pour positionner ledit bloc de jonction (9) sur ledit siège de connexion (81), ledit élément de positionnement (100, 100') ayant un premier corps de plaque (102) disposé au-dessus dudit côté supérieur (91) dudit bloc de jonction (9) et formé avec un ensemble de trous de positionnement (103) qui sont alignés avec lesdits trous d'insertion de sondes (92) dans ledit côté supérieur (91) dudit bloc terminal (9) et un deuxième corps de plaque (104) connecté audit premier corps de plaque (102), s'étendant jusque dans ladite seconde ouverture (61) dans ledit élément de couvercle (6), et engageant ledit côté d'entrée (93) dudit bloc de jonction (9) sans couvrir lesdits trous d'insertion d'entrée (931), ledit premier corps de plaque (102) étant formé avec des montants de pivotement opposés (101) qui sont retenus de façon pivotante dans lesdites rainures de pivotement (63), les sondes d'essai (4) pouvant ainsi être directement insérées dans lesdits trous d'insertion de sondes (92) à travers lesdits trous de positionnement (103) sans faire pivoter ledit élément de positionnement (100, 100'), conférant ainsi une commodité dans ledit module durant son utilisation.

2. Module de contrôleur selon la revendication 1, dans lequel chacune desdites rainures de pivotement (63) a un partie de col supérieure restreinte (631) et une partie de réception inférieure plus large (632), chacun desdits montants de pivotement (101) étant reçu dans ladite partie de réception inférieure (632) et ayant une dimension plus grande que celle de la partie de col supérieure (631) et plus petite que celle de la partie de réception inférieure (632).

3. Module de contrôleur selon la revendication 1 ou 2, dans lequel ledit élément de positionnement (100') comporte en outre un troisième corps de plaque (105) avec une partie de connexion (1051) connectée à une jonction desdits premier et deuxième corps de plaque (102, 104), et une partie de positionnement (1052) connectée à ladite partie de connexion (1051) et s'étendant parallèlement audit deuxième corps de plaque (104), ladite partie de positionnement (1052) étant formée avec un ensemble d'encoches alignées avec lesdits trous d'insertion de sondes (931).

4. Module de contrôleur pour appareil électrique, comprenant une unité de circuit (8) disposée dans un boîtier (5) et étant exposée au niveau d'une extrémité ouverte (51) du boîtier (5) et couplée électriquement à un circuit de commande (80) dans le boîtier (5), un siège de connexion (81) ayant un ensemble de premiers contacts conducteurs (811),
un bloc de jonction (9) monté de façon détachable dans le boîtier (5) et ayant un côté de montage (94) doté de deuxièmes contacts conducteurs (941) qui sont connectés amoviblement à des contacts respectifs des premiers contacts conducteurs (811),
un côté d'entrée (93) opposé au côté de montage (94) et formé avec des trous d'insertion d'entrée (931) pour l'insertion de bornes externes (110), et un côté supérieur (91) formé avec des trous d'insertion de sondes (92) pour l'insertion de sondes d'essai (4),
et un élément de positionnement (100) monté de façon pivotante sur le boîtier (5) pour positionner le bloc de jonction (9) sur le siège de connexion (81), et ayant des trous de positionnement correspondants (103) aménagés dans celui-ci,
et dans lequel les sondes d'essai (4) peuvent être directement insérées dans les trous d'insertion de sondes (92) à travers les trous de positionnement (103) sans faire pivoter l'élément de positionnement (100), conférant ainsi une commodité dans ledit module durant son utilisation.
